# EUROPEAN PATENT SPECIFICATION

(11) **EP 3 022 778 B1**
(45) Date of publication and mention of the grant of the patent: **26.06.2019**
(21) Application number: 14752406.0
(22) Date of filing: 02.07.2014
(51) Int. Cl.: H01L 33/20, H01L 33/40, H01L 33/46, H01L 33/38, H01L 33/42

(54) **A HIGHLY REFLECTIVE LED CHIP**
HOCHREFLEKTIERENDER LED CHIP
PUCE DE DEL HAUTEMENT RÉFLÉCHISSANTE

(30) Priority: 18.07.2013 US 201361847603 P
(43) Date of publication of application: 25.05.2016
(73) Proprietor: Lumileds Holding B.V., 1118 CL Schiphol (NL)
(72) Inventor: LOPEZ, Toni, NL-5656 AE Eindhoven (NL); CHOY, Kwong-Hin Henry, NL-5656 AE Eindhoven (NL)
(74) Representative: ter Heegde, Paul Gerard Michel
(86) International application number: PCT/IB2014/062786
(87) International publication number: WO 2015/008184

(56) References cited:
- DE-A1-102007 019 776
- JP-A- H11 340 514
- JP-A- 2003 347 589
- US-A1- 2007 176 188
- US-A1- 2010 078 670
- US-A1- 2012 025 256

## Description

### FIELD OF THE INVENTION

This invention relates to the metallization of light emitting diodes (LEDs) having a wavelength conversion layer, such as phosphor layer, and, in particular, to a technique for metalizing surfaces of such an LED die to improve the upward reflection of light.

### BACKGROUND

One type of conventional LED is a blue-light-emitting LED with a phosphor layer deposited over its top light-emitting surface. The LED is usually GaN based. The blue light energizes the phosphor, and the wavelength-converted light emitted by the phosphor is combined with the blue light that leaks through the phosphor. Virtually any color may thus be created, such a white light.

One issue regarding such phosphor-converted LEDs (PCLEDs), discussed in more detail below, is that the light emitted by the phosphor layer is isotropic, where some light is emitted upwards and exits the LED die and some light is emitted in a direction back into the semiconductor portion of the die. Most of this light is then reflected back upwards by the metal contacts on the bottom surface of the LED die. In order to minimize reflectivity losses, the metal contacts should feature very high reflectivity characteristics in the entire visible spectrum, which is often times difficult to achieve.

LED package efficiency is the ability to extract light from the LED after it has been generated/converted. Improving such package efficiency is today considered one of the main obstacles in increasing the luminous efficacy of LEDs.

Increased package efficiency in phosphor converted LEDs can be achieved by increasing the reflectivity of the LED die in architectures such as flip-chips.

In flip-chip (FC) die architectures, light is extracted from the semiconductor N-type layer that typically is the "top" semiconductor surface. The P-type layer is the "bottom" semiconductor layer facing the mounting substrate (e.g., a printed circuit board). Metal contacts (electrodes) are formed on the bottom surface of the die. The N-contact is formed by etching away the P-type layer and active layers (i.e., quantum wells) to expose portions of the N-type layer. A dielectric layer is then patterned over the exposed P-type layer and active layer (in order to avoid short-circuits) within the openings, and a metal layer, such as aluminum, is deposited within the openings to contact the N-type layer. The N-contacts can be arranged in the form of vias across the die and/or grooves around the edge of the die, where current is then spread laterally across the N-type layer. No light is generated over the N-contacts since the active layer has been removed in those areas.

The metal P-contact is usually the largest in surface area, and it is also functionally used as a mirror reflector. The P-contact usually consists of Ag (silver) material. Due to the ability of Ag to migrate, a metal guard sheet layer is generally used to prevent the Ag from migrating into any underlying dielectric layer. Aluminum, and not silver, is typically used for the N-contacts for improved electrical coupling to the N-type layer.

In state-of-the-art technologies, thin-film-flip-chip (TFFC) architectures are achieved by further removing the growth substrate (e.g., the sapphire substrate) followed by a roughening process of the exposed N-layer surface, where the generated (blue) light is extracted from. The roughening improves light extraction by reducing internal reflections.

In phosphor converted TFFC LEDs, a phosphor layer may further be deposited on, or attached to, the roughened N-layer surface, thus converting light from a narrow wavelength range into a well-defined wideband spectrum.

US2012/025256 A1 discloses a light emitting device including several layered light emitting semiconductor portions on a substrate. The substrate is exposed between the light emitting semiconductor portions. The periphery of the layered semiconductor portion is inclined. An n-electrode is disposed on the substrate between the light emitting semiconductor portions and on the exposed surface of the n-type semiconductor layer at the periphery of the light emitting semiconductor portions.

US2010/078670 A1 discloses a light emitting device with an electrode configured to reflect light. DE 10 2007 019776 A1 discloses semiconductor die with openings partly reaching into the semiconductor layers. JP 2003 347589 A discloses a LED comprising semiconductor layers, reflecting layers and insulating layers.

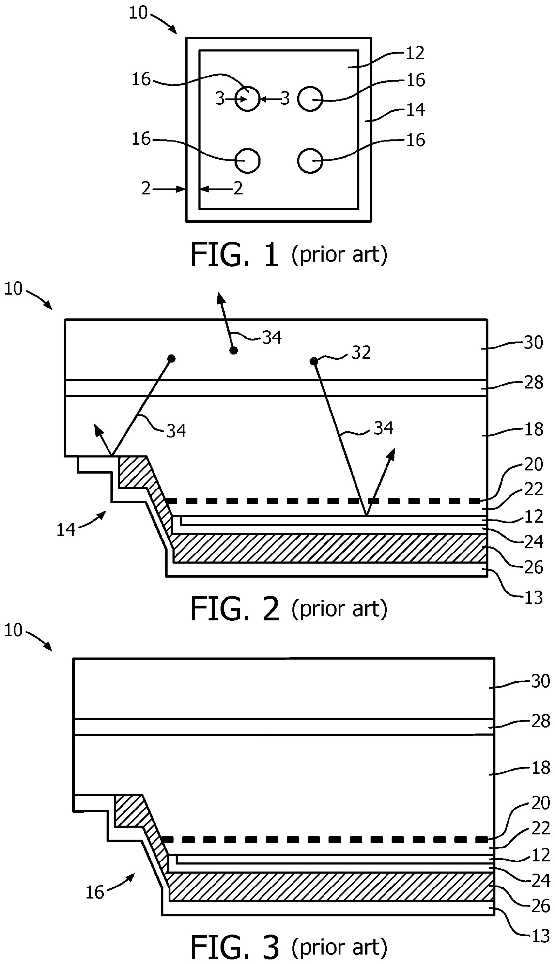

Figs. 1-3 illustrate one type of prior art phosphor converted TFFC LED.

Fig. 1 is a bottom up view of an LED die 10 showing a large metal P-contact layer 12, a narrow N-contact area 14 along the edge where electrical contact is made to the N-type layer, and distributed N-contact areas 16 where additional electrical contacts are made to the N-type layer for good current spreading. The metal layer contacting the N-type layer at areas 14 and 16 is typically Al, which has a reflectivity below 90% for the wavelengths of interest.

Fig. 2 is a cross-sectional view of the edge portion along line 2-2 in Fig. 1. A semiconductor N-type layer 18 is epitaxially grown over a sapphire growth substrate, which has been removed. An active layer 20 and a P-type layer 22 are grown over N-type layer 18. A highly reflectively metal layer (or a stack of metal layers), which may comprise Ag, is then deposited as a P-contact 12 to electrically contact the P-type layer 22. The layers 22 and 20 are etched along the edge to expose the N-type layer 18. A metal guard sheet layer 24 may be deposited on the metal P-contact layer 12 to block the migration of Ag atoms. A dielectric layer 26 is then deposited and etched to expose the N-type layer 18 at area 14. A metal N-contact layer 13 (e.g., Al) is then deposited to electrically contact the N-type layer 18 at area 14 and form a metal ring along the edge of the die 10. In the central area of the LED die 10, the P-contact layer 12 is exposed (see Fig. 1), by etching away the layers 13 and 26, and further metalized to planarize the bottom surface of the LED die 10. If the metal guard sheet layer 24 is used, the electrical contact to the P-contact layer 12 may be made through the metal guard sheet layer 24. The P and N-metal contact layers 12 and 13 are ultimately bonded to corresponding metal anode and cathode pads on a mounting substrate.

Fig. 3 is a cross-sectional view along line 3-3 in Fig. 1 showing a portion of a distributed N-contact area 16, where the N-type layer 18 is contacted by the metal N-contact layer 13. The metallization and etching to create the N-type layer 18 contact at area 16 are performed at the same time the contact is made to the edge area 14.

The sapphire growth substrate may be removed by laser lift-off or other process. The exposed top N-type layer surface 28 is then roughened (e.g., by etching or grinding) to improve light extraction. A phosphor layer 30 is then deposited or otherwise affixed (as a tile) to the top surface.

It will be assumed the phosphor layer 30 is a YAG phosphor that generates a yellow-green light, which, when combined with blue light, results in white light. When a photon generated by the active layer 20 energizes a phosphor particle 32 (Fig. 2), the resulting wavelength-converted light is usually scattered isotropically, so a significant portion of the energy is direct back into the LED die. Fig. 2 illustrates some energized phosphor particles 32 emitting light rays 34 upward and downward. The downward light is ideally reflected upward by the metal N-contact layer 13 at areas 14 and 16 and the P contact layer 12. However, the N-contact layer 13 is typically aluminum, which is not a good reflector. Accordingly, light that impinges on the N-contact layer 13 at areas 14 and 16 is significantly attenuated. Good package efficiency relies upon a high metal contact reflectivity to avoid light absorption in the die.

Besides the limited reflectivity of the N-contact layer 13 at areas 14 and 16, the package efficiency of LED dies like shown above is also limited by the capability of the textured N-type layer surface 28 to extract light from the GaN semiconductor material (a high index material, e.g., n= 2.5) to the lower index phosphor layer (e.g., n= 1.6).

Thus, what is needed is an LED die structure that mitigates such limitations, resulting in superior package efficiency.

### SUMMARY

One purpose of the proposed invention, defined in claim 1, is to increase the effective reflectivity of the die area exposed to the phosphor layer light, where the wavelength-converted light is emitted isotropically. To achieve this, the following techniques are used in one embodiment of the present invention:
Highly reflective regions are added to an otherwise conventional LED die that contribute to an overall higher die reflectivity. These highly reflective regions should be located at areas on the die for efficiently reflecting light generated by the phosphor layer. In one embodiment, the highly reflective regions are in areas that do not generate light. The percentage of the highly reflective area relative to the total die area should be significant (e.g., up to 50%). In order to keep the same area of quantum wells (where electrons are converted into photons) as in standard LED die sizes, the active layer area (and consequently the phosphor area) is increased generally in proportion to the added highly reflective area.

The highly reflective regions are distributed around the central portion of the die. The reflective regions may be used as electrical contact regions to the N-type layer, or even the P-type layer.

The transparent growth substrate (e.g., sapphire) is not removed, and the phosphor layer is ultimately provided over the top surface of the substrate. The highly reflective regions are within trenches etched through the semiconductor layers that expose the substrate. The exposed surfaces are then coated with a highly reflective material, such as Ag. If the reflective material is a metal, proper electrical isolation may be needed. The reflective metal in the trenches may or may not carry current to the N-type layer. In one embodiment, the electrical contacting of the P-type layer is not affected by the invention, since the P-contacts are already highly reflective.

In another embodiment, a dielectric layer, having a relatively low index of refraction, is formed between the substrate and the highly reflective metal layer, or between the GaN and the metal layer, to create an index of refraction mismatch at the dielectric layer surface. Therefore, light incident on the interface at greater than the critical angle will reflect by total internal reflection without losses, and light that enters the dielectric layer will be reflected by the metal layer.

Instead of, or in addition to, a reflective metal creating the highly reflective regions, the reflective layer may be a distributed Bragg reflector using stacked dielectric layers having thicknesses and indices of refraction selected so as to reflect 100% of the wavelengths of interest.

By not removing the growth substrate (e.g., sapphire), the substrate helps to scatter the downward light from the phosphor layer to reduce internal reflections, the substrate provides good mechanical support, and the substrate (having an index of about n=1.8) reduces internal reflections by providing an index between that of the GaN (n=2.5) and the phosphor (n=1.6).

The substrate may undergo texture patterning on its growth side prior to growing the epitaxial layers to improve light extraction at the epitaxial layer-substrate interface.

Other embodiments are described.

### BRIEF DESCRIPTION OF THE DRAWINGS

Fig. 1 is a bottom up view of a prior art flip-chip LED die, showing the metal contact areas.
Fig. 2 is a cross-sectional view of the LED die edge along line 2-2 in Fig. 1.
Fig. 3 is a cross-sectional view of a portion of a distributed contact area along line 3-3 in Fig. 1.
Fig. 4 is a bottom up view of an LED die in accordance with one embodiment of the invention.
Fig. 5 is a cross-sectional view of a portion of the highly reflective region along line 5-5 in Fig. 4.
Fig. 6 is a cross-sectional view of a portion of the highly reflective region along line 5-5 in Fig. 4 in accordance with another embodiment of the invention where the highly reflective metal electrically contacts the N-type layer.
Fig. 7 is a cross-sectional view of an edge portion of the highly reflective region along line 7-7 in Fig. 4.
Fig. 8 is a cross-sectional view of an edge portion of the highly reflective region along line 7-7 in Fig. 4, where the edge of the substrate is coated with a reflector rather than phosphor.
Fig. 9 is a cross-sectional view of a portion of a distributed N-contact along line 9-9 in Fig. 4 showing how the highly reflective metal electrically contacts the N-type layer.
Fig. 10 is an alternative cross-sectional view along line 5-5 of Fig. 4, illustrating how the dielectric layer may be between the substrate and the highly reflective metal for enhancing reflectivity.
Fig. 11 is an alternative cross-sectional view along line 5-5 of Fig. 4, illustrating how the dielectric layer of Fig. 10 may be opened so the reflective metal may contact the N-type layer.
Fig. 12 is an alternative cross-sectional view along line 7-7 of Fig. 4, illustrating how a first metal layer may contact the N-type layer, and a higher reflectivity metal layer may be formed over a dielectric layer. The phosphor layer extends over the sides of the substrate.
Fig. 13 is an alternative cross-sectional view along line 7-7 of Fig. 4, illustrating how a first metal layer may contact the N-type layer, and a higher reflectivity metal layer may be formed over a dielectric layer. A reflector is formed on the sidewalls of the substrate.
Fig. 14 is an alternative cross-sectional view along line 7-7 of Fig. 4, illustrating how the metal reflective layer, formed over a dielectric layer, may contact the N-type layer, similar to Fig. 7.
Fig. 15 is an alternative cross-sectional view along line 9-9 of Fig. 4, illustrating how the metal reflective layer, formed over a dielectric layer, may contact the N-type layer, similar to Fig. 9.
Fig. 16 is a magnified view of a highly reflective area illustrating how dielectric layers may be stacked to form a distributed Bragg reflector (DBR) instead of, or in addition to, using a highly reflective metal layer.

Elements that are the same or similar are labeled with the same numeral.

### DETAILED DESCRIPTION

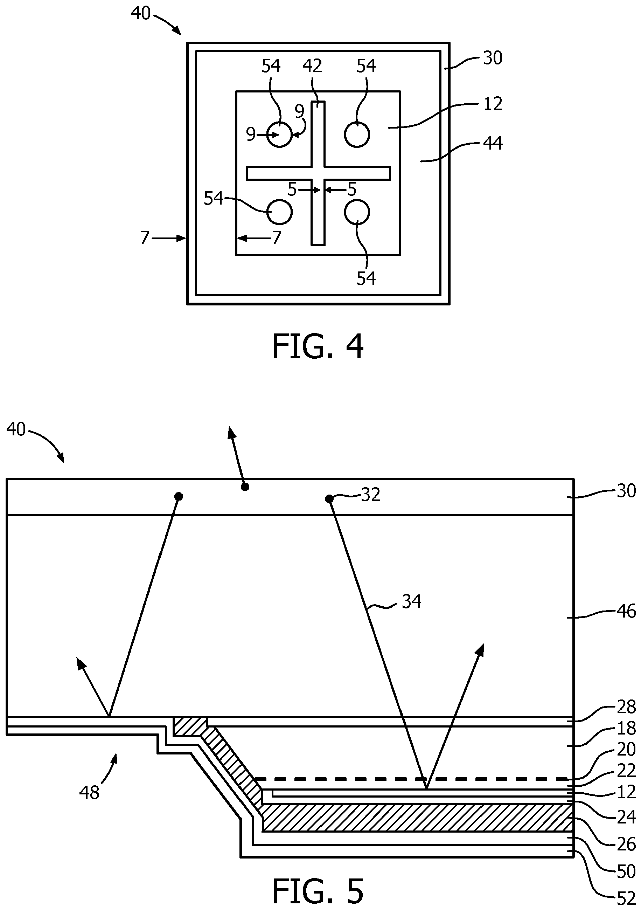

Fig. 4 is a bottom up view of an LED die 40 in accordance with one embodiment of the invention. The LED die 40 includes an added highly reflective region 42 that may or may not serve as an electrical contact. Also, the perimeter of the LED die 40 includes a relatively wide highly reflective edge region 44, in comparison to Fig. 1. In one embodiment, the area of the active layer 20 is the same as the prior art so that similar electrical specifications apply to both. However, the LED die 40 is made larger due to the added area for the regions 42 and 44, and the light output is increased due to the increased package efficiency.

In the embodiments shown, the prior art P-contact layer 12 is not significantly changed since the P-contact layer 12 (comprising of Ag) is already a good reflector.

In one embodiment, the LED die 40 has sides on the order of 1mm x 1mm.

In the example of Fig. 4, the region 42 is formed as a cross; however, it may be any shape and preferably designed to provide a fairly uniform light output across the top surface of the LED die 40. Region 42 may take up from 10%-50% of the die surface area. Since the region 42 removes a portion of the active layer 20, the die may be made larger to compensate for the loss of light generation area.

Fig. 5 is a cross-sectional view of a portion of the highly reflective region 42 along line 5-5 in Fig. 4.

The transparent sapphire growth substrate 46 is not removed. The substrate 46 is optionally thinned prior to depositing the phosphor layer 30. The phosphor layer 30 may be coated on the substrate 46 surface using any number of well-known techniques or may be affixed as a pre-formed tile to the substrate 46 surface.

A trench 48 (formed as a cross in Fig. 4) is then etched through the various layers to expose the transparent substrate 46 surface.

The P-contact layer 12 metal (e.g., Ag) is deposited over the P-type layer 22 (which may be done prior to or after forming the trench 48. The guard sheet layer 24 and dielectric layer 26 are then deposited and patterned to expose the substrate 46 but cover the P-contact layer 12.

On the exposed surface of the substrate 46 and over any portion of the dielectric layer 26, a highly reflective layer 50, such as Ag or an alloy, is then deposited and patterned. The reflectivity of Ag is about 95% for the wavelengths of interest, while the reflectivity of Al is less than 90% at the wavelengths of interest.

A guard sheet layer 52 may then be deposited over the reflective layer 50 if Ag migration is a concern.

The reflective layer 50, guard sheet layer 24, and dielectric layer 26 are patterned to expose the P-contact layer 12 at areas out of the view of Fig. 5 so the exposed P-contact layer 12 can be used as an anode electrode when mounting to a submount or printed circuit board. Any reflective layer 50 under the P-contact layer 12 is not exposed to light and would only be used for electrically contacting the N-type layer 18.

Fig. 5 illustrates various phosphor particles 32 emitting light rays 34 in different directions. Light is shown being reflected off the Ag P-contact layer 12 as well as the Ag layer forming the reflective layer 50. Elsewhere, light may also be reflected off the reflective layer 50 located in the distributed contact areas 54 (Fig. 4) and along the edges of the die.

In the example of Fig. 5, there is no electrical contact made between the reflective layer 50 and the N-type layer 18.

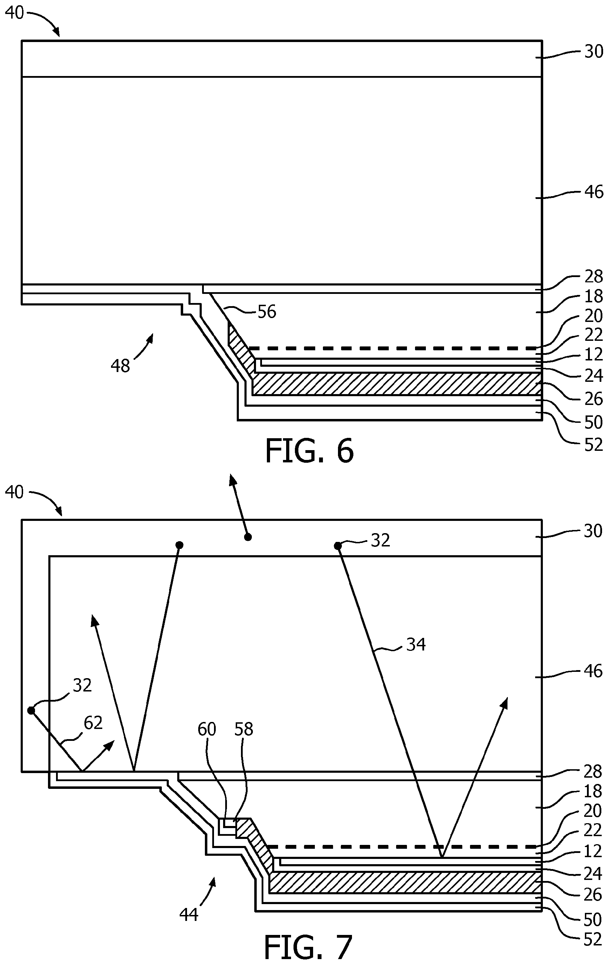

Fig. 6 is an alternative embodiment, not being part of the invention, along line 5-5 in Fig. 4 but where electrical contact is made to the N-type layer 18 by the reflective layer 50 at area 56, where the dielectric layer 26 has been etched away. The narrow contact area 56 extends all the way around the edge of the cross-shaped pattern in Fig. 4 for good current spreading. Accordingly, the guard sheet layer 52 and the reflective layer 50 may form part of the bottom cathode electrode that is bonded to a submount or printed circuit board.

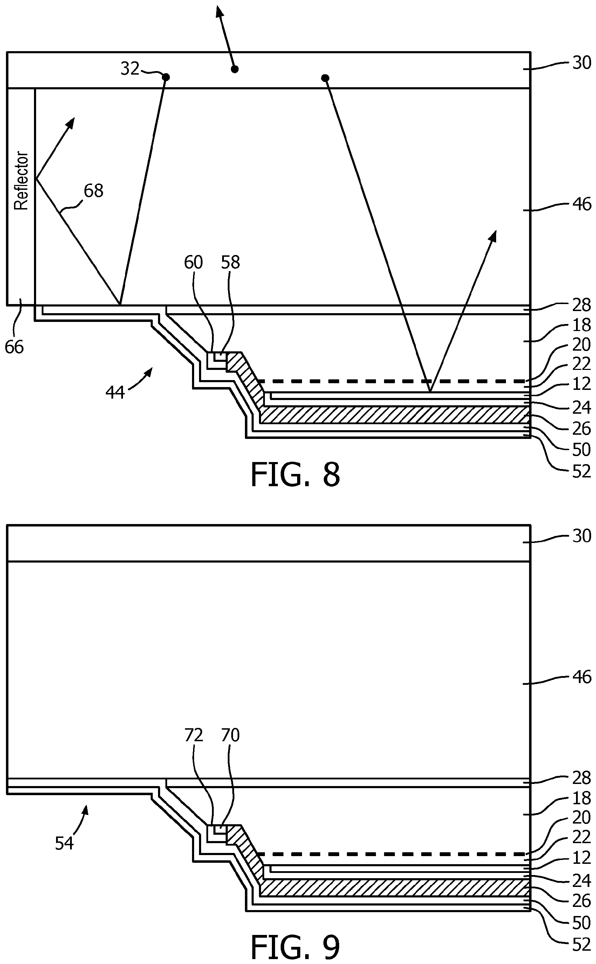

Fig. 7 is a cross-sectional view of an edge portion of the die 40 showing the highly reflective region 44 along line 7-7 in Fig. 4, with the addition of the phosphor layer 30 extending around the side walls of the substrate 46. The manufacture of the various layers may be the same as described above. An edge of the die 40 is etched to expose the substrate 46, and the various layers, including the reflective layer 50 (e.g., Ag), are deposited as shown. Fig. 7 also shows the reflective layer 50 making electrical contact to the N-type layer 18 using a metal ring 58 that circumscribes the central portion of the die 40. The metal used to form the ring 58 may comprise aluminum and may be a conventional metal stack conventionally used to make ohmic contact with N-type GaN. The ring 58 is deposited and patterned simultaneously with the metal used to make contact with the N-type layer 18 in the distributed contact areas 54 shown in Fig. 4, discussed later with respect to Fig. 9. Although electrical contact to the N-type layer by the reflective layer 50 along the edge may be made simply by opening up the dielectric layer 26, as shown in Fig. 6, the interface metals forming the ring 58 and guard sheet layer portion 60 provide an interface for a better electrical connection. Such an interface may also be used in Fig. 6.

To block migration of the Ag atoms from the reflective layer 50, a guard sheet layer portion 60 is formed as a barrier between the metal ring 58 and the reflective layer 50. The guard sheet layer portion 60 may be formed simultaneously with the guard sheet layer 24.

The dielectric layer 26 isolates the reflective layer 50 and metal ring 58 from the metal P-contact layer 12 (which may also comprise Ag for high reflectivity).

Fig. 7 illustrates phosphor particles 32 emitting light rays 34 in various directions. Note how one particle 32 emits a light ray 62 that is reflected off the reflective layer 50 along the edge. If the reflective layer 50 is used for an N-contact, the reflective layer will typically extend to a bottom surface of the die to serve as a cathode electrode. Alternatively, the reflective layer 50 may be electrically connected to another type of less-reflective metal that extends along the bottom surface of the die 40, since any metal that is below the metal P-contact layer 12 does not receive any light. For a cathode electrode, other well-known metals may be deposited over the reflective layer 50, such as Ni and Au, to facilitate bonding to metal pads of a submount or printed circuit board.

As seen by a comparison of Figs. 1 and 4, the edge that is etched is much wider, and no light is generated along the edge. However, the die 40 may be made larger to compensate for the loss of the light generating area. The package efficiency will, however, be greater than that of the die 10 in Fig. 1 since there is increased reflectance of the light generated by not only the phosphor layer 30 but by the active layer 20. Therefore, the LED die 40 will have the same electrical specifications as the prior art LED die 10 of Fig. 1 but will be brighter.

In one embodiment, the area of the trench 48 around the edge of the die 40 that is covered by the reflective layer 50 is 10%-50% of the die 40 surface area.

Fig. 8 is similar to Fig. 7 but the edge of the substrate 46 is coated with a reflector 66 rather than phosphor. The substrate 46 may be many times thicker than the LED semiconductor layers and thus the light emitted from the sides is significant. If such side light is not desired, then forming the reflector 66 is recommended. The reflector 66 may be Ag or other suitable material. Fig. 8 shows a light ray 68 from a phosphor particle 32 being reflected off both the reflective layer 50 and the reflector 66.

Fig. 9 is a cross-sectional view of a portion of a distributed N-contact along line 9-9 in Fig. 4 showing how the reflective layer 50 electrically contacts the N-type layer 18 via a metal contact 70 forming a narrow ring within the circular etched opening in the LED layers. The metal contact 70 is the same metal forming the metal ring 58 in Fig. 7 and formed at the same time. Although Fig. 4 shows four identical distributed contact areas 54, there may be many more for improved current uniformity. The distributed contact areas 54 may be circular or generally frustum-shaped, as shown, or may be rectangular or other shapes. The metal contact 70 would therefore take the shape of the edge of the contact area 54. A guard sheet layer portion 72 is also shown, which is formed simultaneously with the guard sheet layer portion 60 in Fig. 7. Electrical contact to the N-type layer 12 is made by the various electrical contacts shown in Figs. 6, 7, and 9 to evenly spread current.

Therefore, since the distributed contact areas 54 and the reflective edge region 44 will reflect about 95% of the impinging light from the phosphor layer 30, and the P-contact layer 12 is also highly reflective, very little phosphor light is absorbed by the die 40, in contrast to the die 10 of Fig. 1 where there is significant absorption by the metal N-contact layer 13 at the areas 14 and 16. Accordingly, the overall efficiency of the LED is improved.

In another embodiment, instead of adding the trench 48 to form the cross-shaped reflective layer 50, the distributed contact areas 54 are made larger than the distributed areas 16 in Fig. 1, where the electrical contact to the N-type layer 18 is made along the edges of the contact areas 54 (shown in Fig. 9) and the central areas of the contact areas 54 are solely for adding the highly reflective areas. Note that, in the prior art Fig. 3 and in contrast to Fig. 9, the distributed areas 16, for contacting the N-type layer 18, are solely for making electrical contact with the N-type layer 18, and the contact metal used significantly absorbs the phosphor light.

The areas of the highly reflective regions, using Ag, are preferably much larger than the areas where the N-contact metal, typically Al, contacts the N-type layer 18, and the Al should only be used for the electrical interface between the reflective layer 50 and the N-type layer 18. Preferably the Al should only occupy no more than the strictly necessary for good electrical contact to the N-type layer 18, such as providing a contact width not larger than 2^{∗}Lt, where Lt is the transfer length of the metal-semiconductor contact, typically about 1um. The remaining exposed regions are preferably covered by the highly reflective metal (e.g., Ag). The highly reflective layer 50 may or may not be used as a current carrier while still achieving the goals of the present invention.

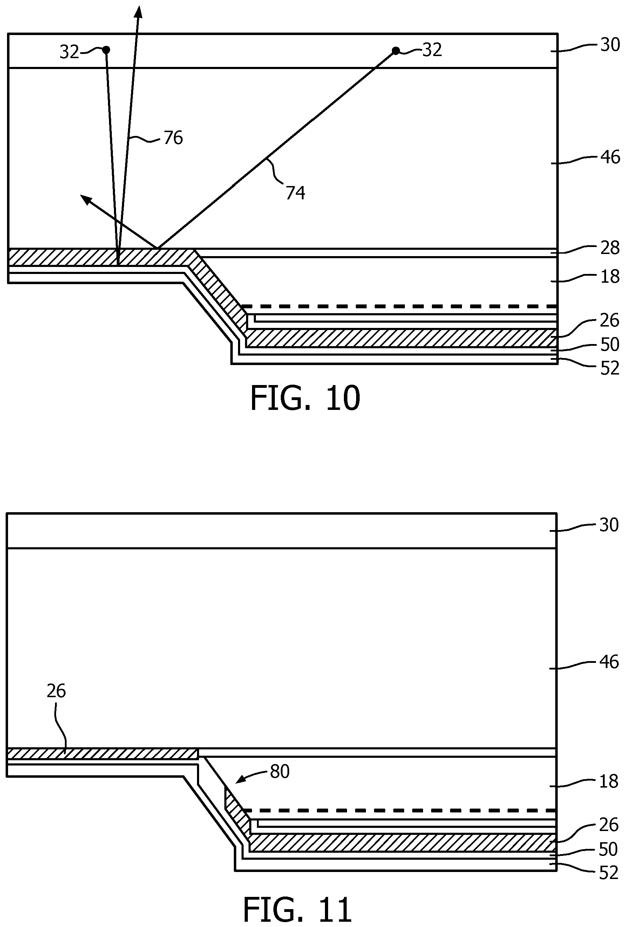

Fig. 10 illustrates how the dielectric layer 26 may be between the substrate 46 and the metal highly reflective layer 50 for enhancing reflectivity. The index of refraction of the dielectric layer 26 (e.g., 1-4-1.5) is selected to be lower than that of the substrate 46. Fig. 10 may illustrate any of the areas of high reflectivity, such as across lines 5-5, 7-7, or 9-9 of Fig. 4. Therefore, light incident the interface at greater than the critical angle, such as light ray 74, will reflect by total internal reflection without losses, and light that enters the dielectric layer 26, such as light ray 76, will be reflected by the reflective layer 50.

Further, in one example, a thinned N-type layer 18, including the N-type layer surface 28, may extend to the left edge of Fig. 10. If the dielectric layer 26 and reflective layer 50 are formed over the thinned N-type layer 18, the relatively low index of the dielectric layer 26 will cause light incident at larger than the critical angle to reflect off the GaN/dielectric interface without losses. Light that enters the dielectric layer 26 will be reflected by the reflective layer 50. The reflective layer 50 may or may not carry current for the N-type layer 18.

The lower the refractive index of the dielectric layer 26, the lower the critical angle (in accordance with Snell's law) and hence the larger the range of the light rays that will be fully reflected at the interface by total internal reflection.

Fig. 11 is an alternative cross-sectional view along line 5-5 of Fig. 4 (or other edges of a reflective area), not being part of the invention, illustrating how the dielectric layer 26 of Fig. 10 may be opened at area 80 so the metal reflective layer 50 may electrically contact the N-type layer 18 to carry N-type layer 18 current.

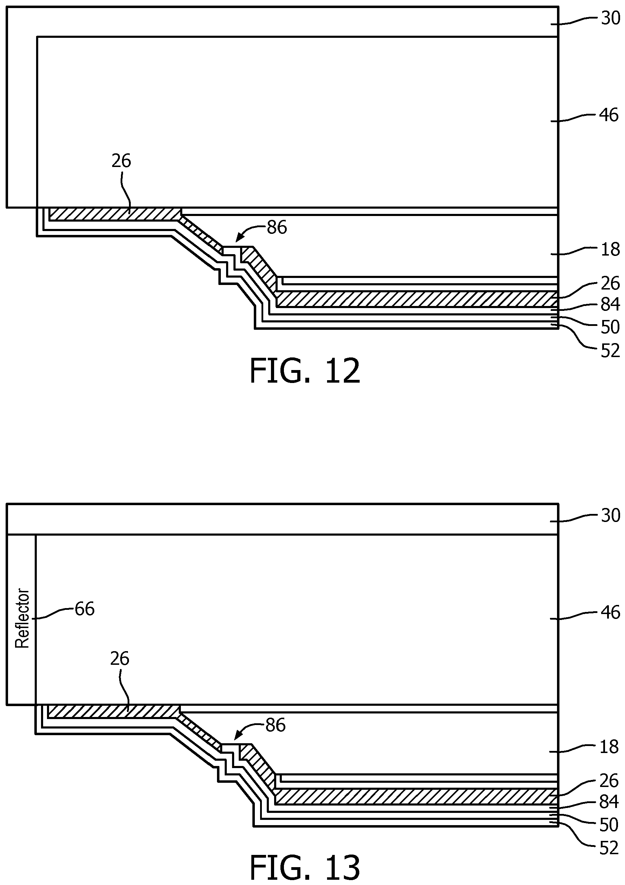

Fig. 12 is an alternative cross-sectional view along line 7-7 of Fig. 4, illustrating how a first metal layer 84 (e.g., aluminum) may contact the N-type layer 18 at area 86 through an opening in the dielectric layer 26. The reflective layer 50, formed of a higher reflectivity metal such as Ag, may be formed over the first metal layer 84 and over the dielectric layer 26. As in Figs. 10 and 11, the dielectric layer 26 contacting the substrate 46 reflects some light by total internal reflection. The phosphor layer 30 extends over the sides of the substrate.

Fig. 13 is an alternative cross-sectional view along line 7-7 of Fig. 4, illustrating how the first metal layer 84 may contact the N-type layer 18 near the edges of the die. Fig. 13 differs from Fig. 12 in that a reflector 66 is formed over the sidewalls of the substrate 46.

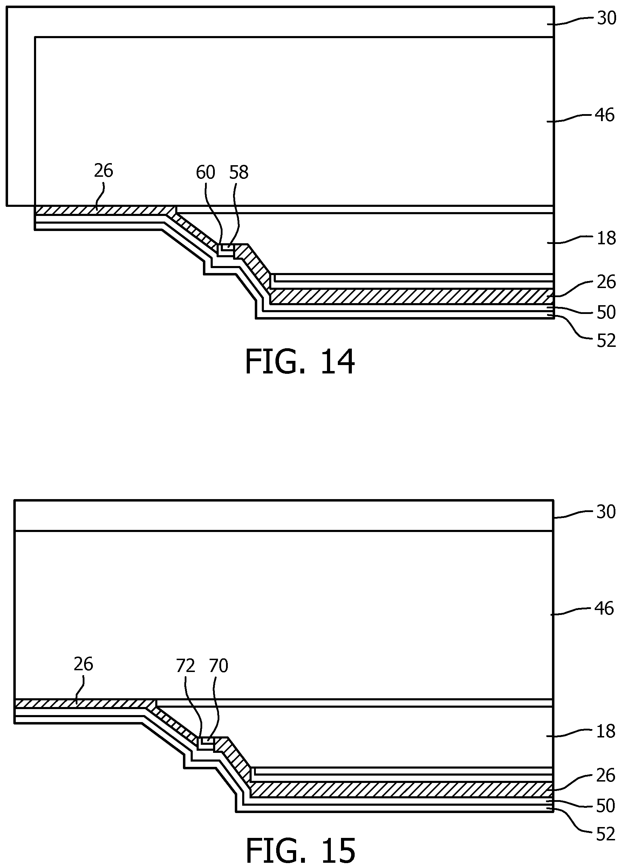

Fig. 14 is an alternative cross-sectional view along line 7-7 of Fig. 4, and similar to Fig. 7, illustrating how the metal reflective layer 50, formed over the dielectric layer 26, may contact the N-type layer 18 via a metal ring 58 and a guard sheet layer portion 60..

Fig. 15 is an alternative cross-sectional view along line 9-9 of Fig. 4, illustrating how the metal reflective layer 50, formed over the dielectric layer 26, may contact the N-type layer 18 using a metal contact 70 and guard sheet layer portion 72, similar to Fig. 9.

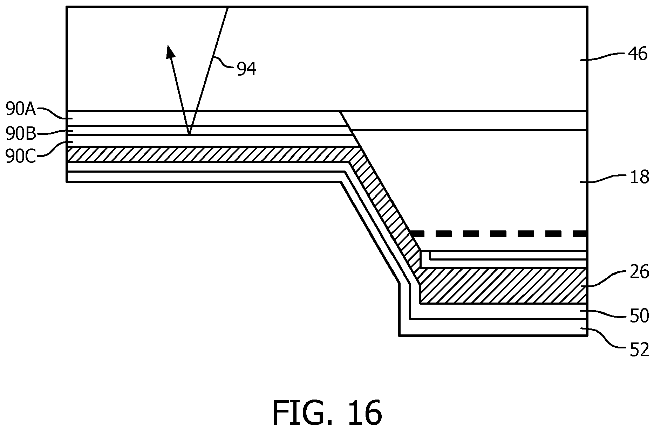

Instead of, or in addition to, a reflective metal creating the highly reflective regions, the reflective layer may be a distributed Bragg reflector (DBR), as shown in Fig. 16, using stacked dielectric layers 90A, 90B, and 90C, having thicknesses and indices of refraction selected so as to reflect 100% of the wavelengths of interest. In an actual embodiment, there may be many more stacked layers. Forming DBRs is well known for other applications. Light (e.g., light ray 94) that fully penetrates the DBR will be reflected by the metal layer forming the reflective layer 50. The metal layer may be optional. The DBR may be formed below the P-type layer 22 for use as a dielectric layer and may be an extension of the dielectric layer 26.

Note that the DBR could also be extended over the mesa sidewalls to obtain mesa sidewall reflectance.

By not removing the growth substrate 46, the substrate helps to scatter the downward light from the phosphor layer to reduce internal reflections, the substrate 46 provides good mechanical support, and the substrate 46 (having an index of about n=1.8) reduces internal reflections by providing an index between that of the GaN (n=2.5) and the phosphor layer 30 (n=1.6). The growth surface of the substrate 46 may be roughed to further improve light extraction by reducing internal reflections.

Additionally, since the phosphor layer 30 is separated from the semiconductor layers, there is less heat transferred to the phosphor layer 30, allowing the use of phosphors that have lower temperature requirements.

Instead of a phosphor layer, any other wavelength conversion layer may be located over the substrate 46, such as a quantum dot layer. The wavelength conversion layer does not have to be in direct contact with the substrate 46.

While particular embodiments of the present invention have been shown and described, it will be obvious to those skilled in the art that changes and modifications may be made within the scope of the appended claims.

## Claims

1. A light emitting diode (LED) die structure comprising:
LED semiconductor layers including an N-type layer (18), a P-type layer (22), an active layer (20) that emits light;
a growth substrate (46) having a first surface and a second surface opposing the first surface;
the N-type layer (18), the P-type layer (22), and the active layer (20) being grown on the first surface;
the N-type layer (18), the P-type layer (22), and the active layer (20) being arranged so that at least a portion of the light generated by the active layer (20) enters the first surface of the growth substrate (46) and exits through the second surface of the growth substrate (46);
a wavelength conversion layer (30) overlying the second surface of the growth substrate (46);
wherein the first surface of the growth substrate (46) is at least partly exposed forming distributed contact areas (54) for a metal contact (58, 70) for one of the LED semiconductor layers;
the distributed contact areas (54) are formed by one or more openings (54) in the LED semiconductor layers distributed around a central portion of the LED die;
the metal contact (58, 70) is formed along the edges of the one or more openings (54), not in the central area of the openings (54);
**characterized in that**:
a highly reflective material (50) is deposited in the central areas of the one or more openings (54) covering at least a portion of the first surface of the growth substrate (46) so as to reflect light from the wavelength conversion layer (30).

2. The structure of Claim 1 wherein the reflective material (50) is a metal directly contacting the substrate.

3. The structure of Claim 2 wherein the reflective material (50) conducts current for the N-type layer (18).

4. The structure of Claim 2 wherein the reflective material (50) is electrically insulated from the N-type layer (18).

5. The structure of Claim 1 wherein the one or more openings (54) comprise an opening (30) along an edge of the LED die.

6. The structure of Claim 1 wherein the one or more openings (54) comprise an opening (42) along the central portion of the LED die.

7. The structure of Claim 6 wherein the opening (42) along the central portion of the LED die forms a cross shape.

8. The structure of Claim 1 wherein the one or more openings (54) comprise openings distributed across the LED die.

9. The structure of Claim 1 wherein the metal contact (58, 70) comprises an N-contact metal ring along an edge of each of the openings distributed across the LED die but not in a central area of the openings (54), for electrically connecting the reflective material (50) to the N-type layer (18).

10. The structure of Claim 1 wherein the structure further comprises electrical contact areas between the N-type layer (18) and the reflective material along an edge of each of the openings (54) but not in a central area of the openings (54), for electrically connecting the reflective material (50) to the N-type layer (18).

11. The structure of Claim 1 wherein the structure further comprising a continuous electrical contact area between the N-type layer (18) and the reflective material (50) along an edge of the opening, but not in a central area of the opening, for electrically connecting the reflective material to the N-type layer.

12. The structure of Claim 1 wherein the reflective material (50) comprises Ag.

13. The structure of Claim 1 wherein the reflective material (50) is a first metal layer electrically contacting the N-type layer (18), the structure further comprising a second metal layer (12) electrically contacting the P-type layer (22), wherein the first metal layer and second metal layer terminate in anode and cathode electrodes on a bottom surface of the LED die.

14. The structure of Claim 1 wherein the wavelength conversion layer (30) is a phosphor layer also formed over side walls of the growth substrate (46).

15. The structure of Claim 1 further comprising a reflector (66) formed over side walls of the growth substrate (46).

16. The structure of Claim 1 wherein the reflective material (50) comprises a dielectric stack (90A, 90B, 90C) forming a distributed Bragg reflector.

17. The structure of Claim 1 further comprising a dielectric layer (26) between the growth substrate (46) and the reflective material (50).

18. The structure of Claim 1 wherein a guard sheet layer portion (60) is formed between the metal contact (58) and the reflective layer (50).

## Patentansprüche

1. Leuchtdioden (LED)-Die-Struktur, umfassend:
LED-Halbleiterschichten, aufweisend eine n-leitende Schicht (18), eine p-leitende Schicht (22), eine aktive Schicht (20), die Licht emittiert;
ein Wachstumssubstrat (46) mit einer ersten Oberfläche und einer zweiten Oberfläche gegenüber der ersten Oberfläche;
wobei die n-leitende Schicht (18), die p-leitende Schicht (22) und die aktive Schicht (20) auf die erste Oberfläche aufgewachsen sind;
die n-leitende Schicht (18), die p-leitende Schicht (22) und die aktive Schicht (20) so angeordnet sind, dass wenigstens ein Teil des durch die aktive Schicht (20) erzeugten Lichts in die erste Oberfläche des Wachstumssubstrats (46) eintritt und durch die zweite Oberfläche des Wachstumssubstrats (46) austritt;
eine Wellenlängenumwandlungsschicht (30), die auf der zweiten Oberfläche des Wachstumssubstrats (46) aufliegt;
wobei die erste Oberfläche des Wachstumssubstrats (46) wenigstens teilweise freigelegt ist und verteilte Kontaktbereiche (54) für einen Metallkontakt (58, 70) für eine der LED-Hableiterschichten bildet;
die verteilten Kontaktbereiche (54) durch eine oder mehrere Öffnungen (54) in den LED-Halbleiterschichten ausgebildet sind, die um einen mittigen Teil des LED-Dies verteilt sind;
der Metallkontakt (58, 70) entlang der Ränder der einen oder der mehreren Öffnungen (54), nicht im mittigen Bereich der Öffnungen (54), ausgebildet ist;
**dadurch gekennzeichnet, dass**:
ein hoch reflektierendes Material (50) in die mittigen Bereiche der einen oder der mehreren Öffnungen (54) abgeschieden ist und wenigstens einen Teil der ersten Oberfläche des Wachstumssubstarts (46) bedeckt, um Licht von der Wellenlängenumwandlungsschicht (30) zu reflektieren.

2. Struktur nach Anspruch 1, wobei das reflektierende Material (50) ein Metall ist, welches das Substrat direkt kontaktiert.

3. Struktur nach Anspruch 2, wobei das reflektierende Material (50) Strom für die n-leitende Schicht (18) leitet.

4. Struktur nach Anspruch 2, wobei das reflektierende Material (50) von der n-leitenden Schicht (18) elektrisch isoliert ist.

5. Struktur nach Anspruch 1, wobei die eine oder die mehreren Öffnungen (54) eine Öffnung (30) entlang eines Randes des LED-Dies umfassen.

6. Struktur nach Anspruch 1, wobei die eine oder die mehreren Öffnungen (54) eine Öffnung (42) entlang des mittigen Teils des LED-Dies umfassen.

7. Struktur nach Anspruch 6, wobei die Öffnung (42) entlang des mittigen Teils des LED-Dies eine Kreuzform bildet.

8. Struktur nach Anspruch 1, wobei die eine oder die mehreren Öffnungen (54) Öffnungen umfassen, die über den LED-Die verteilt sind.

9. Struktur nach Anspruch 1, wobei der Metallkontakt (58, 70) einen n-Kontakt-Metallring entlang eines Randes einer jeden der Öffnungen, die über den LED-Die verteilt sind, aber nicht in einem mittigen Bereich der Öffnungen (54), zum elektrischen Verbinden des reflektierenden Materials (50) mit der n-leitenden Schicht (18) umfasst.

10. Struktur nach Anspruch 1, wobei die Struktur ferner elektrische Kontaktbereiche zwischen der n-leitenden Schicht (18) und dem reflektierenden Material entlang eines Randes einer jeden der Öffnungen (54), aber nicht in einem mittigen Bereich der Öffnungen (54), zum elektrischen Verbinden des reflektierenden Materials (50) mit der n-leitenden Schicht (18) umfasst.

11. Struktur nach Anspruch 1, wobei der Struktur ferner einen durchgehenden elektrischen Kontaktbereich zwischen der n-leitenden Schicht (18) und dem reflektierenden Material (50) entlang eines Randes der Öffnung, aber nicht in einem mittigen Bereich der Öffnung, zum elektrischen Verbinden des reflektierenden Materials mit der n-leitenden Schicht umfasst.

12. Struktur nach Anspruch 1, wobei das reflektierende Material (50) Ag umfasst.

13. Struktur nach Anspruch 1, wobei das reflektierende Material (50) eine erste Metallschicht ist, welche die n-leitende Schicht (18) elektrisch kontaktiert, wobei die Struktur ferner eine zweite Metallschicht (12) umfasst, welche die p-leitende Schicht (22) elektrisch kontaktiert, wobei die erste Metallschicht und die zweite Metallschicht in Anoden- und Kathodenelektroden auf einer Unterseite des LED-Dies enden.

14. Struktur nach Anspruch 1, wobei die Wellenlängenumwandlungsschicht (30) eine Phosphorschicht ist, die auch über Seitenwände des Wachstumssubstrats (46) ausgebildet ist.

15. Struktur nach Anspruch 1, ferner umfassend einen Reflektor (66), der über Seitenwände des Wachstumssubstrats (46) ausgebildet ist.

16. Struktur nach Anspruch 1, wobei das reflektierende Material (50) einen dielektrischen Stapel (90A, 90B, 90C) umfasst, der einen verteilten Bragg-Reflektor bildet.

17. Struktur nach Anspruch 1, ferner umfassend eine dielektrische Schicht (26) zwischen dem Wachstumssubstrat (46) und dem reflektierenden Material (50).

18. Struktur nach Anspruch 1, wobei ein Schutzfolienschichtteil (60) zwischen dem Metallkontakt (58) und der reflektierenden Schicht (50) ausgebildet ist.

## Revendications

1. Structure de puce de diode électroluminescente (DEL) comprenant :
des couches semi-conductrices de DEL comportant une couche de type N (18), une couche de type P (22), une couche active (20) qui émet de la lumière ;
un substrat de croissance (46) ayant une première surface et une seconde surface opposée à la première surface ;
la couche de type N (18), la couche de type P (22) et la couche active (20) étant formées par croissance sur la première surface ;
la couche de type N (18), la couche de type P (22) et la couche active (20) étant agencées de sorte qu'au moins une partie de la lumière générée par la couche active (20) pénètre dans la première surface du substrat de croissance (46) et sort à travers la seconde surface du substrat de croissance (46) ;
une couche de conversion de longueur d'onde (30) se superposant à la seconde surface du substrat de croissance (46) ;
dans lequel la première surface du substrat de croissance (46) est au moins partiellement exposée, formant des zones de contact réparties (54) pour un contact métallique (58, 70) pour une des couches semi-conductrices de DEL ;
les zones de contact réparties (54) sont formées par une ou plusieurs ouvertures (54) dans les couches semi-conductrices de DEL réparties autour d'une partie centrale de la puce de DEL ;
le contact métallique (58, 70) est formé le long des bords des une ou plusieurs ouvertures (54), pas dans la zone de contact des ouvertures (54) ;
**caractérisée en ce que** :
un matériau hautement réfléchissant (50) est déposé dans les zones centrales des une ou plusieurs ouvertures (54) couvrant au moins une partie de la première surface du substrat de croissance (46) de sorte à réfléchir la lumière à partir de la couche de conversion de longueur d'onde (30).

2. Structure selon la revendication 1, dans laquelle le matériau réfléchissant (50) est un métal en contact direct avec le substrat.

3. Structure selon la revendication 2, dans laquelle le matériau réfléchissant (50) conduit un courant pour la couche de type N (18).

4. Structure selon la revendication 2, dans laquelle le matériau réfléchissant (50) est isolé électriquement de la couche de type N (18).

5. Structure selon la revendication 1, dans laquelle les une ou plusieurs ouvertures (54) comprennent une ouverture (30) le long d'un bord de la puce de DEL.

6. Structure selon la revendication 1, dans laquelle les une ou plusieurs ouvertures (54) comprennent une ouverture (42) le long de la partie centrale de la puce de DEL.

7. Structure selon la revendication 6, dans laquelle l'ouverture (42) le long de la partie centrale de la puce de DEL présente une forme de croix.

8. Structure selon la revendication 1, dans laquelle les une ou plusieurs ouvertures (54) comprennent des ouvertures réparties à travers la puce de DEL.

9. Structure selon la revendication 1, dans laquelle le contact métallique (58, 70) comprend un anneau métallique à contact N le long d'un bord de chacune des ouvertures réparties à travers la puce de DEL mais pas dans une zone centrale des ouvertures (54), pour connecter électriquement le matériau réfléchissant (50) à la couche de type N (18).

10. Structure selon la revendication 1, dans laquelle la structure comprend en outre des zones de contact électriques entre la couche de type N (18) et le matériau réfléchissant le long d'un bord de chacune des ouvertures (54) mais pas dans une zone centrale des ouvertures (54) pour connecter électriquement le matériau réfléchissant (50) à la couche de type N (18).

11. Structure selon la revendication 1, dans laquelle la structure comprend en outre une zone de contact électrique continue entre la couche de type N (18) et le matériau réfléchissant (50) le long d'un bord de l'ouverture, mais pas dans une zone centrale de l'ouverture, pour connecter électriquement le matériau réfléchissant à la couche de type N.

12. Structure selon la revendication 1, dans laquelle le matériau réfléchissant (50) comprend de l'Ag.

13. Structure selon la revendication 1, dans laquelle le matériau réfléchissant (50) est une première couche métallique en contact électrique avec la couche de type N (18), la structure comprenant en outre une seconde couche métallique (12) en contact électrique avec la couche de type P (22), dans laquelle la première couche métallique et la seconde couche métallique se terminent par des électrodes d'anode et de cathode sur une surface de fond de la puce de DEL.

14. Structure selon la revendication 1, dans laquelle la couche de conversion de longueur d'onde (30) est une couche de phosphore également formée sur des parois latérales du substrat de croissance (46).

15. Structure selon la revendication 1, comprenant en outre un réflecteur (66) formé sur des parois latérales du substrat de croissance (46).

16. Structure selon la revendication 1, dans laquelle le matériau réfléchissant (50) comprend un empilement diélectrique (90A, 90B, 90C) formant un réflecteur de Bragg réparti.

17. Structure selon la revendication 1, comprenant en outre une couche diélectrique (26) entre le substrat de croissance (46) et le matériau réfléchissant (50).

18. Structure selon la revendication 1, dans laquelle une partie de couche de feuille de protection (60) est formée entre le contact métallique (58) et la couche réfléchissante (50).
